# FASCICULE DE BREVET EUROPEEN

(11) **EP 0 724 332 B1**
(45) Date de publication et mention de la délivrance du brevet: **08.10.2003**
(21) Numéro de dépôt: 96400166.3
(22) Date de dépôt: 24.01.1996
(51) Int. Cl.: H03K 17/10, H03K 17/691, H01F 19/08

(54) **Dispositif de commutation d'un circuit de haute tension à transformateur d'impulsions**
Schaltvorrichtung für Hochspannungsschaltung mit Impulstransformator
Switching device for a high voltage circuit with pulse transformers

(30) Priorité: 26.01.1995 FR 9500894
(43) Date de publication de la demande: 31.07.1996
(73) Titulaire: COMMISSARIAT A L'ENERGIE ATOMIQUE, 75015 Paris (FR)
(72) Inventeur: Chatroux Daniel, F-26200 Montelimar (FR); Guyon, Yves, F-84840 La Palud (FR); Guidini, Rodophe, F-13004 Marseille (FR)
(74) Mandataire: Poulin, Gérard

(56) Documents cités:
- DE-A- 3 912 704
- GB-A- 2 183 952

## Description

### DOMAINE TECHNIQUE

L'invention concerne un dispositif de commutation à haute fréquence pour un circuit de haute tension avec des transformateurs d'impulsion.

Un tel dispositif de commutation permet des ouvertures et des fermetures rapides d'un circuit de haute tension à partir d'impulsions de commande d'un circuit de basse tension. On entend par haute tension une tension de quelques dizaines à quelques centaines de kilovolts et par fréquence élevée, une fréquence s'étendant de quelques kilohertz à quelques mégahertz.

L'invention trouve des applications dans des domaines tels que les alimentations pour lasers impulsionnels, les générateurs d'impulsions rapides, les alimentations et convertisseurs haute tension.

### ETAT DE LA TECHNIQUE ANTERIEURE

La demande de brevet GB 2 183 952 montre un dispositif pour commuter une électrode de grille d'un tube à faisceau électronique entre deux tensions de commande de polarités opposées. Ce dispositif comporte deux interrupteurs commandés en opposition de phase à l'aide de deux premiers transformateurs présentant une isolation de haute tension, de deux deuxièmes transformateurs et d'un circuit amplificateur.

Pour commuter des circuits de haute tension, on utilise en général un nombre important d'étages de transistors à grille isolée. A titre d'exemple, pour la réalisation d'interrupteurs ou de dispositifs de commutation susceptibles d'une tenue en tension de 20 à 100 kilovolts, de 50 à 100 étages de transistors montés en série sont nécessaires. La mise en conduction et le blocage des transistors se fait en réponse à des impulsions de commande dans un circuit de basse tension. Ces commandes de basse tension sont transmises aux transistors ou aux commutateurs par l'intermédiaire d'un dispositif capable d'assurer une isolation galvanique entre le circuit de basse tension et le circuit de haute tension dans lequel sont montés les interrupteurs. La transmission des impulsions de commande ou des ordres de commande peut avoir lieu, par exemple, par des transformateurs d'impulsion.

Des dispositifs de commutation avec des transformateurs d'impulsion sont connus par exemple dans les documents (1) et (2) référencés à la fin de la présente description. Comme décrit dans le document (1), pour commander une pluralité de transistors ou de commutateurs dans le circuit de haute tension, il est possible d'utiliser un transformateur d'impulsion commun pour l'ensemble des commutateurs. Un tel transformateur comporte une pluralité d'étages secondaires reliés respectivement à chacun des commutateurs.

Dans l'exemple de réalisation du document (1), le transformateur d'impulsion assure l'isolation galvanique entre le circuit primaire, c'est-à-dire le circuit de basse tension sur lequel sont fournies les impulsions de commande, et chaque circuit secondaire, relié à la haute tension, et comportant un commutateur. Le transformateur assure également l'isolation entre les différents étages secondaires. La réalisation d'un transformateur qui permet l'isolation galvanique entre les étages primaires et secondaires et entre les différents étages secondaires présente un certain nombre de difficultés.

La réalisation d'une isolation galvanique de qualité, dictée par les impératifs de tenue à une tension élevée dans la gamme de la présente application, entraîne la création de self-inductions de fuite assez importantes entre les bobinages du transformateur. Ainsi, un transformateur d'impulsion unique à plusieurs secondaires n'est pas bien adapté à la construction de commutateurs de haute tension qui soient suffisamment rapides, c'est-à-dire susceptibles de fonctionner dans la gamme de fréquences recherchée. Des transformateurs d'impulsion avec une pluralité de circuits secondaires ne permettent pas en effet des commutations avec des fronts de commutation de l'ordre de la nanoseconde à quelques centaines de nanosecondes.

Le document (2) illustre une variante de réalisation d'un dispositif de commutation qui utilise non pas un seul transformateur avec plusieurs étages secondaires mais utilise une pluralité de transformateurs dont les étages primaires sont reliés en série dans un circuit de basse tension. Chaque transformateur comporte un noyau torique et chaque noyau torique est traversé par un câble électrique isolé qui forme respectivement le primaire de chaque transformateur et qui est monté dans le circuit de basse tension. Ce câble présente une isolation par rapport à la haute tension, et chaque transformateur comporte aussi un circuit secondaire formé par un enroulement autour du tore et relié respectivement à un commutateur. Dans ce cas, l'isolation galvanique entre l'étage primaire commun et les étages secondaires des transformateurs ainsi que l'isolation galvanique entre les différents étages secondaires des transformateurs est assurée par l'isolation du câble du circuit primaire. Cette isolation doit donc être en mesure de tenir la haute tension et à la haute fréquence.

Or on sait que la durée de vie en haute tension d'un câble isolé décroît rapidement lorsque le champ électrique dans le conducteur augmente. Le phénomène qui influence la tenue dans le temps de l'isolation est lié à des décharges partielles dans l'isolant du câble.

Que ce soit dans un régime électrique alternatif ou impulsionnel, le champ électrique entre différents matériaux isolants consécutifs croît comme l'inverse de la perméabilité relative. Ainsi, le champ dans une bulle d'air piégée dans un isolant solide est plus important que le champ électrique dans le matériau solide lui-même. Dès que le champ dépasse le champ de claquage dans l'air, un plasma apparaît dans la bulle d'air, ce plasma étant susceptible de dégrader l'isolant. Ce phénomène physique qui se traduit essentiellement par l'apparition de décharges partielles dans les isolants solides limite leurs performances et leur durée de vie.

De plus, le vieillissement dû aux décharges partielles augmente sensiblement linéairement avec la fréquence de fonctionnement. Ce vieillissement est donc particulièrement rapide pour les dispositifs à haute fréquence. A titre d'exemple, pour un dispositif de commutation qui comporte une pluralité de transformateurs d'impulsion toriques traversés par un unique câble qui forme leur étage primaire, une isolation suffisante de ce câble suppose un diamètre extérieur de celui-ci de l'ordre de 10mm pour une tenue en tension de 20kV.

Ainsi, un dispositif réalisé conformément au document (2) ne permet ainsi pas de commander un nombre de transistors très grand pour commuter une haute tension à une fréquence élevée. En effet, pour satisfaire aux exigences de fiabilité, il est nécessaire d'utiliser des câbles équipés d'une gaine d'isolation épaisse, c'est-à-dire des câbles primaires dont le diamètre est important. Le diamètre intérieur des tores des noyaux des transformateurs doit également être dimensionné en conséquence. Or, du fait des contraintes de fabrication, lors du frittage des ferrites, qui forment les noyaux toriques des transformateurs et qui sont des matériaux céramiques, il est difficile de fabriquer un tore qui ait à la fois une section faible et un diamètre important. Des tores présentant une section de quelques mm² pour un diamètre de quelques cm ne sont ainsi pas disponibles en standard. Les tores vendus dans le commerce respectent un rapport quasi-constant entre leur diamètre et leur section. Un tore d'un diamètre de quelques cm a une section de l'ordre du cm² par exemple.

Pour une réalisation d'un dispositif conforme au document (2) dans lequel on associe à chaque transistor un transformateur, le volume total occupé par les tores mais aussi le coût du matériau magnétique qui les constitue est prohibitif dans les applications envisagées dans le cadre de la présente invention.

Une solution alternative consisterait en l'usage de transformateurs ayant plusieurs bobinages secondaires autour de chaque tore pour limiter le nombre de tores et donc le volume qu'ils occupent. Une telle solution est toutefois écartée en raison de son incompatibilité avec les impératifs de la fabrication industrielle et notamment de la fabrication en série.

Un objet de la présente invention est donc de proposer un dispositif de commutation d'un circuit de haute tension à transformateurs d'impulsion qui soit à la fois performant du point de vue de la rapidité des commutations, de la fiabilité dans le temps et qui soit d'une compacité raisonnable pour la réalisation de commutateurs en haute et très haute tension, rapides et à fréquence de récurrence élevée.

Un autre objet de l'invention est de proposer un dispositif dont la réalisation soit non seulement de faible coût mais aussi compatible avec les exigences d'une fabrication industrielle.

### Exposé de l'invention

Pour atteindre ces objets, l'invention concerne plus particulièrement un dispositif de commutation d'un circuit de haute tension à transformateur d'impulsion tel que défini dans la revendication 1. Il comporte une pluralité de commutateurs avec des interrupteurs connectés en série dans le circuit de haute tension, des moyens de transformation d'impulsion connectés d'une part à un circuit basse tension et d'autre part auxdits commutateurs et permettant de fournir des impulsions de commutation pour les commutateurs en réponse à des impulsions de commande dans un circuit de basse tension.

Selon l'invention, les moyens de transformation d'impulsion comportent au moins un premier transformateur avec un étage primaire pour recevoir les impulsions de commande et un étage secondaire, chaque étage secondaire de chaque premier transformateur est relié à des étages primaires respectivement d'une pluralité de deuxièmes transformateurs pour fournir des impulsions de commutation à ladite pluralité de commutateurs reliés respectivement à la pluralité de deuxièmes transformateurs, et chaque premier transformateur présente une isolation galvanique supérieure à celle des deuxièmes transformateurs.

Ainsi, grâce à l'invention, la tenue en tension entre le circuit de basse tension et le circuit de haute tension est essentiellement assurée par chaque premier transformateur qui a une isolation galvanique importante. La pluralité de deuxièmes transformateurs qui est associée aux transistors, n'ayant pas à supporter une différence de potentiel très importante peuvent être de petite taille et surtout présenter un noyau de faible volume. Ainsi, avec un seul transformateur de volume plus important, et une pluralité de transformateurs de plus faible volume, il est possible de commander une pluralité de transistors. Bien entendu, il est possible, lorsque le nombre de transistors à commander est très grand, d'utiliser plusieurs premiers transformateurs, chacun étant associé à une pluralité de deuxièmes transformateurs. Ainsi, dans une application particulière de l'invention où les transformateurs sont des transformateurs toriques, il est possible d'utiliser un ou plusieurs premiers transformateurs dont le noyau torique est plus important que celui des deuxièmes transformateurs. Globalement, il s'avère que, pour une commutation de tensions identiques, le volume occupé par les transformateurs est très inférieur au volume occupé par les transformateurs des dispositifs de commutation connus, par exemple ceux des dispositifs des documents (1) et (2) précédemment décrits. Lorsque le dispositif de l'invention comporte une pluralité de premiers transformateurs, ceux-ci peuvent avoir leurs étages primaires reliés en série dans le circuit de basse tension. Dans le cas particulier où les transformateurs sont du type à noyau torique, un unique câble à forte isolation électrique peut former l'étage primaire en traversant l'ensemble des noyaux des premiers transformateurs.

Selon un aspect avantageux de l'invention le noyau du premier transformateur peut être électriquement relié à l'étage secondaire du premier transformateur et les noyaux des deuxièmes transformateurs sont électriquement reliés au circuit de haute tension. Ainsi, l'isolation galvanique entre le circuit de basse tension et le circuit de haute tension est essentiellement fournie par l'isolation d'étages primaires du ou des premiers transformateurs.

Lorsque le ou les premiers transformateurs sont des transformateurs à noyau torique, l'isolation sera fournie par le câble formant l'étage primaire. A cet effet, le circuit de basse tension peut comporter par exemple une tige métallique rigide qui traverse le ou les noyaux toriques des premiers transformateurs en formant respectivement leur étage primaire. Cette tige est alors isolée des noyaux par exemple par un moulage solide.

Selon un aspect particulier de l'invention, l'étage secondaire du premier transformateur peut comporter un enroulement unique relié aux étages primaires des deuxièmes transformateurs montés en série, il peut s'agir également d'un câble traversant des noyaux toriques des deuxièmes transformateurs.

Il est possible d'envisager plusieurs solutions pour relier les deuxièmes transformateurs au commutateur. Une solution consiste, par exemple à utiliser des deuxièmes transformateurs avec un étage secondaire unique, c'est-à-dire avec un unique enroulement relié respectivement à un commutateur. Il est possible également d'utiliser des deuxièmes transformateurs avec une pluralité d'enroulements reliés respectivement à une pluralité de commutateurs.

Les commutateurs sont construits essentiellement autour de transistors du type à effet de champ. Ces transistors peuvent être par exemple des transistors MOS, c'est-à-dire avec une structure métal oxyde semi-conducteur, des transistors IGBT qui sont des transistors bipolaires à grille isolée ainsi que des transistors MCT. Les grilles des transistors ou les électrodes de commande de ces derniers sont reliées à l'étage secondaire des transformateurs par exemple par un circuit de commande intermédiaire.

D'autres caractéristiques et avantages de l'invention ressortirons mieux de la description qui va suivre, donnée à titre purement illustratif et non limitatif, en référence aux figures annexées.

### Brève description des figures

- la figure 1 est une représentation schématique d'un dispositif de commutation conforme à l'invention,
- les figures 2 à 5 illustrent des exemples d'interrupteurs du dispositif de commutation et leur circuit de commande associé,
- la figure 6 est une vue à plus grande échelle ce premier et deuxième transformateurs du dispositif de la figure 1.

### Description détaillée d'un mode de mise en oeuvre de l'invention

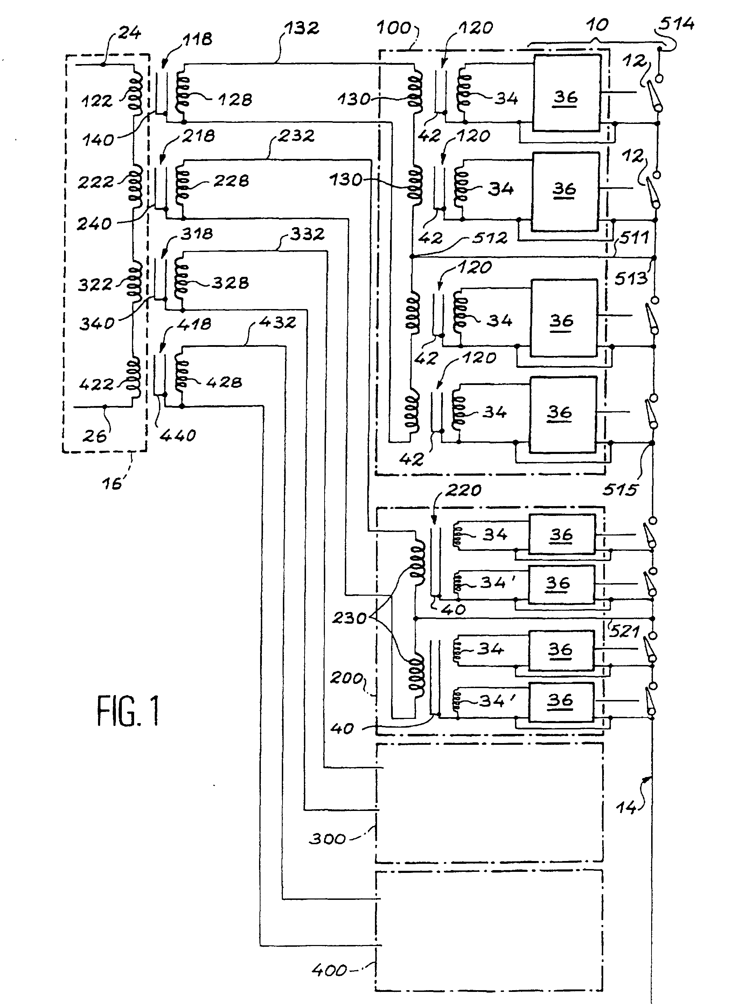

Dans la suite de la description des parties ou éléments, identiques ou similaires des figures 1 à 6 portent les mêmes références.

Sur la figure 1, un dispositif de commutation comporte une pluralité de commutateurs 10 avec des interrupteurs 12 montés en série dans une branche 14 d'un circuit de haute tension.

Pour commander l'ouverture et la fermeture des interrupteurs 12 des impulsions de commande sont formées dans un circuit de basse tension 16, partiellement représenté. Ces impulsions sont transmises aux commutateurs 10 par l'intermédiaire d'une série de premiers transformateurs 118, 218, 318, 418 et une série de deuxièmes transformateurs 120, 220 dont seuls quelques uns sont représentés entièrement sur la figure. Des ensembles référencés 100, 200, 300, 400 désignent respectivement les deuxièmes transformateurs associés aux premiers transformateurs 118, 218, 318 et 418. Pour des raisons de clarté, les ensembles 300 et 400 ne sont pas détaillés sur la figure. Les étages primaires 122, 222, 322, 422 des premiers transformateurs sont formés par une branche du circuit de basse tension 16 qui va d'une borne 24 à une borne 26. Les étages secondaires 128, 228, 328, 428 des premiers transformateurs sont respectivement reliés à des étages primaires des deuxièmes transformateurs. Pour des raisons de clarté de la figure, celle-ci ne représente que les étages primaires 130 et 230 reliés aux étages secondaires 128 et 228 des premiers transformateurs. Les étages primaires 130 et 230 des deuxièmes transformateurs sont respectivement montés en série dans des circuits 132, 232 qui les relient aux premiers transformateurs. Des circuits 332, 432 relient de même les étages 328 et 428 à des deuxièmes transformateurs des ensembles 300 et 400, non représentés. Le nombre de deuxième transformateurs, le nombre d'étages en série, de même que le nombre de premiers transformateurs peuvent être adaptés pour chaque réalisation particulière en fonction de la tension à commuter.

Les étages secondaires des deuxièmes transformateurs sont respectivement reliés aux commutateurs 10. Ces commutateurs comportent un circuit de commande 36 associé à des interrupteurs 12.

Selon des variantes de réalisation du dispositif, les deuxièmes transformateurs peuvent comporter un étage secondaire avec un ou plusieurs enroulements. A titre d'illustration sur la figure 1, les transformateurs 120 comportent un étage secondaire avec un enroulement unique 34, et les transformateurs 230 comportent un étage secondaire avec deux enroulements 34 et 34', reliés respectivement à un interrupteur 12 via un circuit 36.

Conformément à un aspect particulier de l'invention, l'isolation galvanique entre les circuits de basse et de haute tensions est assurée par les étages primaires des transformateurs. Les noyaux 140, 240, 340, 440 des premiers transformateurs et les noyaux 40, 42 des deuxièmes transformateurs sont électriquement reliés respectivement aux circuits 132, 232, 332, 432 et au circuit 14.

On note également sur la figure une liaison 511 qui relie une borne 512 du circuit 132 à une borne 513 de la branche 14 du circuit de haute tension. Cette liaison est avantageusement réalisée à "mi-tension" sur la partie de la branche 14 dont les interrupteurs sont commandés via les transformateurs de référence 118 et 120. Ainsi, l'isolant de l'étage primaire 130 des deuxièmes transformateurs 120 n'a à supporter qu'une fraction, au plus égale à la moitié de la chute de tension aux bornes des interrupteurs associés à un même premier transformateur. A titre d'exemple pour une chute de tension de 6000 volts entre les points 514 et 515 de la branche 14, l'isolation de l'étage primaire 130 doit supporter au maximum 3kV.

Une liaison équivalente 521 relie également le circuit 232 des étages primaires des deuxièmes transformateurs 220 à la branche 14 du circuit de haute tension.

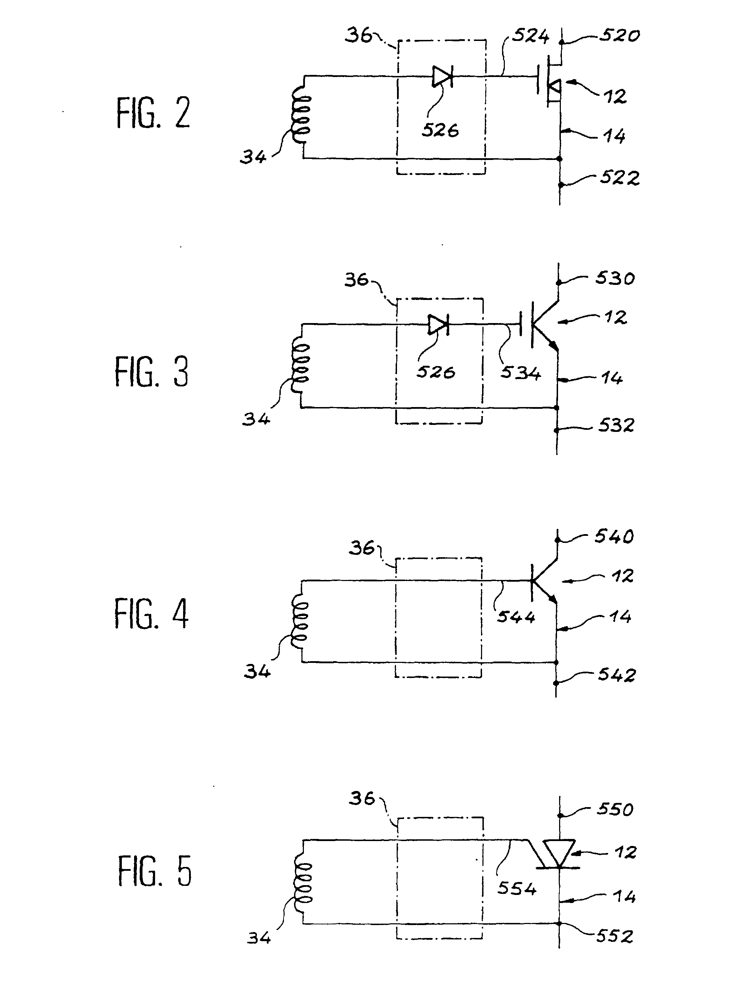

Les figures 2 à 5 illustrent différents modes de réalisation du circuit de commande 36 et des interrupteurs 12.

Dans l'exemple de la figure 2, l'interrupteur 12 est un transistor à effet de champ du type MOSFET (Metal Oxide Semiconductor Field Effect Transistor). Les bornes 520 et 522 qui correspondent à son drain et sa source sont montées dans la branche 14 du circuit de haute tension. Le circuit 36 comporte une diode 526 qui relie une borne de l'enroulement secondaire à la grille 524 ; l'autre borne de l'enroulement étant directement reliée à la source 522.

Dans l'exemple de la figure 3, l'interrupteur 12 est un transistor bipolaire à grille isolée du type IGBT (Insulated Gate Bipolar Transistor). Les bornes 530 et 532 correspondent au collecteur et à l'émetteur et sont montées dans la branche 14. Comme dans le cas de la figure 2, le circuit 36 comporte une diode 526 qui relie la grille 534 à une borne de l'enroulement 34 ; l'autre borne de l'enroulement étant directement reliée à l'émetteur.

Les exemples des figures 2 et 3 correspondent à une commande en tension.

Dans l'exemple de la figure 4, l'interrupteur 12 est un transistor bipolaire dont les bornes 540 et 542 correspondent au collecteur et à l'émetteur et sont montées dans la branche 14 du circuit de haute tension. La base 544 et l'émetteur 542 sont, par ailleurs, directement reliés aux deux bornes de l'enroulement 34.

Dans l'exemple de la figure 5, l'interrupteur 12 est un thyristor dont l'anode 550 et la cathode 552 sont montées dans la branche 14 du circuit de haute tension. La gâchette 554 et la cathode 552 sont, par ailleurs, directement reliées aux deux bornes de l'enroulement 34.

Les exemples des figures 4 et 5 correspondent à une commande en courant.

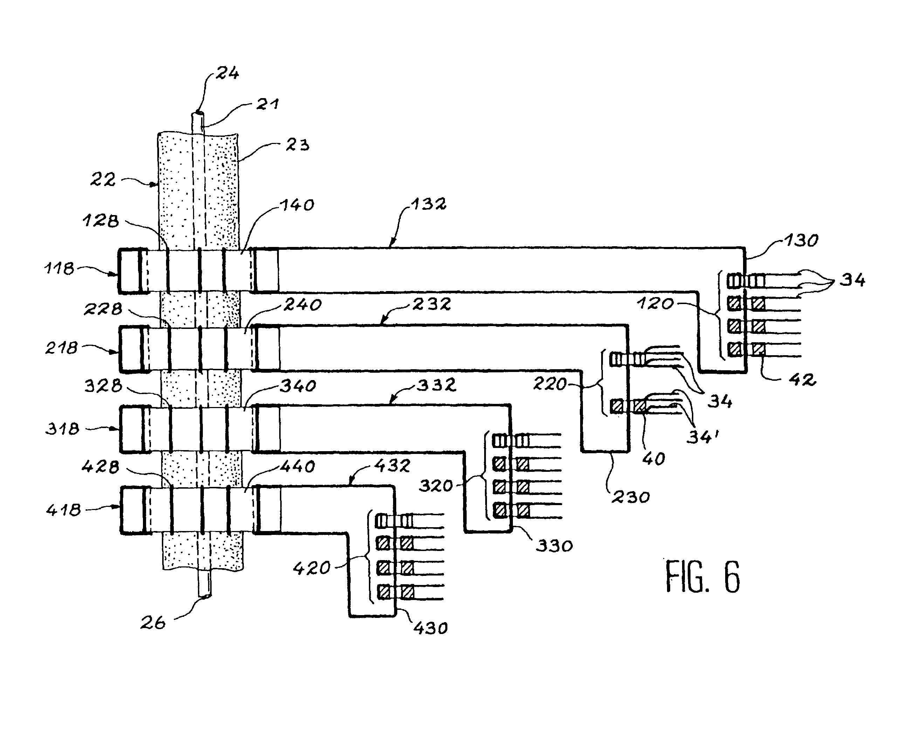

La figure 6 montre à échelle agrandie les premiers et deuxièmes transformateurs.

Dans la réalisation illustrée à la figure 6, les transformateurs sont des transformateurs toriques. Les étages primaires des premiers transformateurs 118, 218, 318, 418 sont réalisés à partir d'un unique câble 22 qui relie les bornes 24 et 26 du circuit de basse tension (non représenté) et qui traverse respectivement les noyaux toriques 140, 240, 340 et 440 des premiers transformateurs.

Le câble 22 comporte une âme électriquement conductrice 21, par exemple en cuivre, d'une section de 4mm² et une gaine isolante 23 en Téflon (nom déposé) et d'une épaisseur de 10mm.

Comme le câble 22 assure à la fois l'isolation galvanique entre les étages primaires et secondaires de chaque premier transformateur et entre les étages secondaires des premiers transformateurs. L'isolation et par conséquent la section des câbles des enroulements des étages secondaires peut être réduite. Le câble 22 occupe ainsi pratiquement tout le diamètre intérieur du tore.

Pour chaque premier transformateur 118, 218, 318, 418, un même câble forme l'enroulement secondaire, respectivement 128, 228, 328, 428, le circuit 132, 232, 332, 432 qui relie respectivement l'enroulement aux deuxièmes transformateurs 120, 220, 320, 420, et l'étage primaire 130, 230, 330, 430 respectivement des deuxièmes transformateurs.

Parmi les deuxièmes transformateurs associés à un premier transformateur, un transformateur a chaque fois été représenté en vue de face et les autres en coupe. Ceci permet de montrer que l'étage primaire des deuxièmes transformateurs est un simple câble isolé qui traverse leurs noyaux toriques.

A l'instar des premiers transformateurs, les deuxièmes transformateurs comportent un (ou plusieurs) enroulements secondaires 34, 34' autour de leur noyau 40. Ces enroulements 34, 34' sont reliés aux commutateurs non représentés sur la figure 6.

Finalement, cette association judicieuse des câbles de diamètre et de capacité de tenue de la tension très différents et des transformateurs de tailles très différentes, c'est-à-dire avec des petits et des gros tores, il est possible, grâce à l'invention, d'obtenir un dispositif de commutation de haute tension à la fois rapide et compact.

Par ailleurs et à titre d'exemple, pour la commutation d'une tension de 60kV le dispositif peut comporter 10 premiers et 6 deuxièmes transformateurs. La tenue en tension de l'isolation de l'étage primaire des premiers transformateurs est par exemple de 60kV tandis que celle de l'étage primaire des deuxièmes transformateurs est simplement de 3kV avec les liaisons à "mi-tension".

## Revendications

1. Dispositif de commutation d'un circuit de haute tension à transformateur d'impulsion comportant :
une pluralité de commutateurs (10) avec des interrupteurs (12) connectés en série dans le circuit de haute tension,
des moyens de transformation d'impulsion (118, 218, 318, 418, 120, 220) connectés d'une part à un circuit basse tension (16) et d'autre part auxdits commutateurs (10), les moyens de transformation d'impulsion comportent au moins un premier transformateur (118, 218, 318, 418) avec un étage primaire (122, 222, 322, 422) pour recevoir les impulsions de commande et un étage secondaire (128, 228, 328, 428),
et permettant de fournir des impulsions de commutation pour les commutateurs (10) en réponse à des impulsions de commande dans le circuit de basse tension (16), **caractérisé en ce que**
le dispositif de commutation est apte à provoquer une ouverture ou une fermeture du circuit de haute tension,
chaque étage secondaire de chaque premier transformateur est relié directement à des étages primaires (130, 230) respectivement d'une pluralité de deuxièmes transformateurs (120, 220) pour fournir des impulsions de commutation à ladite pluralité de commutateurs reliés respectivement à la pluralité de deuxièmes transformateurs,
chaque premier transformateur présente une isolation galvanique supérieure à celle de chacun des deuxièmes transformateurs, les circuits de basse et de haute tensions étant mutuellement isolés par le(s) premier(s) et par les deuxièmes transformateurs.

2. Dispositif selon la revendication 1, **caractérisé en ce que** les premiers (118, 218, 318, 418) et deuxièmes (120, 220) transformateurs sont des transformateurs à noyau torique, le noyau torique (140, 240, 340, 440) de chaque premier transformateur présentant un diamètre supérieur aux noyaux toriques (40, 42) des deuxièmes transformateurs.

3. Dispositif selon la revendication 2, **caractérisé en ce que** le noyau (140, 240, 340, 440) de chaque premier transformateur est électriquement relié à l'étage secondaire (128, 228, 328, 428) du premier transformateur et les noyaux (40, 42) des deuxièmes transformateurs sont électriquement reliés au circuit de haute tension.

4. Dispositif selon la revendication 1, **caractérisé en ce qu'**il comporte une pluralité de premiers transformateurs (118, 218, 318, 418) à noyau torique ayant leurs étages primaires (122, 222, 322, 422) reliés en série dans le circuit de basse tension (16).

5. Dispositif selon la revendication 4, **caractérisé en ce que** les étages primaires (122, 222, 322, 422) des premiers transformateurs comportent un câble à forte isolation électrique traversant les noyaux toriques des premiers transformateurs.

6. Dispositif selon la revendication 4, **caractérisé en ce que** le circuit de basse tension (16) comporte une tige métallique (21) rigide traversant les noyaux toriques des premiers transformateurs (118, 218, 318, 418) et formant respectivement leur étage primaire, ladite tige étant isolée des noyaux par un moulage solide isolant (23).

7. Dispositif selon la revendication 1, **caractérisé en ce que** l'étage secondaire de chaque premier transformateur (118, 218, 318, 418) comporte un enroulement unique (128, 228, 328, 428) relié aux étages primaires (130, 230) d'une pluralité de deuxièmes transformateurs (120, 220) montés en série.

8. Dispositif selon la revendication 7, **caractérisé en ce qu'**il comporte, pour chaque pluralité de deuxièmes transformateurs (120, 220), une liaison électrique (511, 521) reliant, à mi-tension, un circuit (132, 232) comportant les étages primaires (130, 230) de la pluralité de deuxièmes transformateurs, à une partie d'une branche (14) du circuit de haute tension comportant les commutateurs respectivement reliés à ladite pluralité de deuxièmes transformateurs.

9. Dispositif selon la revendication 1, **caractérisé en ce que** les deuxièmes transformateurs (120, 220) présentent un étage secondaire (34) avec un unique enroulement relié à un commutateur (10).

10. Dispositif selon la revendication 1, **caractérisé en ce que** les deuxièmes transformateurs (120, 220) présentent une pluralité d'enroulements (34, 34') reliés respectivement à une pluralité de commutateurs (10).

11. Dispositif selon la revendication 1, **caractérisé en ce que** les commutateurs (10) comportent un circuit de commande (36) relié à l'étage secondaire (34, 34') respectivement des deuxièmes transformateurs (120, 220) et comprenant un transistor à grille isolée (12) monté en série dans le circuit de haute tension.

12. Dispositif selon la revendication 11, **caractérisé en ce que** le transistor (12) est choisi dans le groupe constitué des transistors MOS, IGBT et MCT.

## Patentansprüche

1. Umschaltvorrichtung für Hochspannungsschaltung mit Impulstransformator, umfassend:
eine Vielzahl Umschalter (10) mit Schaltern (12), in Serie geschaltet in der Hochspannungsschaltung,
Impulstransformationseinrichtungen (118, 218, 318, 418, 120, 220), einerseits mit einer Niederspannungsschaltung (16) verbunden und andererseits mit den genannten Umschaltern (10), wobei die Impulstransformationseinrichtungen wenigstens einen ersten Transformator (118, 218, 318, 418) mit einer Primärstufe (122, 222, 322, 422) umfassen, um die Steuerimpulse zu empfangen, und eine Sekundärstufe (128, 228, 328, 428),
und fähig, Schaltimpulse für die Umschalter (10) zu liefern, als Reaktion auf Steuerimpulse in der Niederspannungsschaltung (16),
**dadurch gekennzeichnet,**
**dass** die Umschaltvorrichtung eine Öffnung oder eine Schließung der Hochspannungsschaltung bewirken kann,
**dass** jede Sekundärstufe jedes ersten Transformators direkt mit Primärstufen (130, 230) von jeweils einer Vielzahl zweiter Transformatoren (120, 220) verbunden ist, um der genannten Vielzahl von jeweils mit der Vielzahl zweiter Transformatoren verbundenen Umschaltern Umschaltimpulse zu liefern,
**dass** jeder erste Transformator eine galvanische Isolation aufweist, die stärker ist als die jedes der zweiten Transformatoren, wobei die Nieder- und Hochspannungsschaltungen gegenseitig isoliert sind durch den (die) ersten und durch die zweiten Transformatoren.

2. Vorrichtung nach Anspruch 1, **dadurch gekennzeichnet, dass** die ersten (118, 218, 318, 418) und zweiten (120, 220) Transformatoren Transformatoren mit torischem Kern sind, wobei der torische Kern (140, 240, 340, 440) jedes ersten Transformators einen größeren Durchmesser als die torischen Kerne (40, 42) der zweiten Transformatoren aufweist.

3. Vorrichtung nach Anspruch 2, **dadurch gekennzeichnet, dass** der Kern (140, 240, 340, 440) jedes ersten Transformators elektrisch mit der Sekundärstufe (128, 228, 328, 428) des ersten Transformators verbunden ist, und die Kerne (40, 42) der zweiten Transformatoren elektrisch mit der Hochspannungsschaltung verbunden sind.

4. Vorrichtung nach Anspruch 1, **dadurch gekennzeichnet, dass** sie eine Vielzahl erster Transformatoren (118, 218, 318, 418) mit torischem Kern umfasst, deren Primärstufen (122, 222, 322, 422) in der Niederspannungsschaltung (16) in Serie verbunden sind.

5. Vorrichtung nach Anspruch 4, **dadurch gekennzeichnet, dass** die Primärstufen (122, 222, 322, 422) der ersten Transformatoren ein Kabel mit starker elektrischer Isolation umfassen, das die torischen Kerne der ersten Transformatoren durchquert.

6. Vorrichtung nach Anspruch 4, **dadurch gekennzeichnet, dass** die Niederspannungsschaltung (16) einen steifen Metallstab (21) umfasst, der die torischen Kerne der ersten Transformatoren 1(118, 218, 318, 418) durchquert und jeweils ihre Primärstufe bildet, wobei die genannte Stange von den Kernen isoliert ist durch ein festes Isolationsmaterial (23), in das sie eingegossen ist.

7. Vorrichtung nach Anspruch 1, **dadurch gekennzeichnet, dass** die Sekundärstufe jedes ersten Transformators (118, 218, 318, 418) eine einzige Wicklung (128, 228, 328, 428) umfasst, verbunden mit den Primärstufen (130, 230) einer Vielzahl von in Serie geschalteten zweiten Transformatoren (120, 220).

8. Vorrichtung nach Anspruch 7, **dadurch gekennzeichnet, dass** sie für jede Vielzahl zweiter Transformatoren (120, 220) eine elektrische Verbindung (511, 521) umfasst, die mit halber Spannung eine Schaltung (132, 232) mit den Primärstufen (130, 230) der Vielzahl zweiter Transformatoren mit einem Teil eines Zweigs (14) der Hochspannungsschaltung verbindet, der die jeweils mit der genannten Vielzahl zweiter Transformatoren verbundenen Umschalter umfasst.

9. Vorrichtung nach Anspruch 1, **dadurch gekennzeichnet, dass** die zweiten Transformatoren (120, 220) eine Sekundärstufe (34) mit einer einzigen mit einem Umschalter (10) verbundenen Wicklung umfassen.

10. Vorrichtung nach Anspruch 1, **dadurch gekennzeichnet, dass** die zweiten Transformatoren (120, 220) eine Vielzahl Wicklungen (34, 34') umfassen, die jeweils mit einer Vielzahl von Umschaltern (10) verbunden sind.

11. Vorrichtung nach Anspruch 1, **dadurch gekennzeichnet, dass** die Umschalter (10) eine Steuerschaltung (36) umfassen, die mit der Sekundärstufe (34, 34') von jeweils den zweiten Transformatoren (120, 220) verbunden ist und einen in der Hochspannungsschaltung in Serie geschalteten Transistor mit isolierter Steuerelektrode (12) umfasst.

12. Vorrichtung nach Anspruch 11, **dadurch gekennzeichnet, dass** der Transistor (12) ausgewählt wird aus einer durch MOS-, IGBT- und MCT-Transistoren gebildeten Gruppe.

## Claims

1. Device for switching a pulse-transformer high-voltage circuit comprising:
a plurality of switches (10) with breakers (12) connected in series in the high-voltage circuit,
pulse transformation means (118, 218, 318, 418, 120, 220) connected on the one hand to a low-voltage circuit (16) and on the other hand to the said switches (10), the pulse transformation means comprise at least one first transformer (118, 218, 318, 418) with a primary stage (122, 222, 322, 422) for receiving the control pulses and a secondary stage (128, 228, 328, 428),
and making it possible to provide switching pulses for the switches (10) in response to control pulses in the low-voltage circuit (16), **characterized in that**
the switching device is able to bring about opening or closing of the high-voltage circuit,
each secondary stage of each first transformer is linked directly to primary stages (130, 230) respectively of a plurality of second transformers (120, 220) so as to provide switching pulses to the said plurality of switches linked respectively to the plurality of second transformers,
each first transformer exhibits a greater galvanic isolation than that of each of the second transformers, the low-voltage and high-voltage circuits being mutually isolated by the first transformer or transformers and by the second transformers.

2. Device according to Claim 1, **characterized in that** the first (118, 218, 318, 418) and second (120, 220) transformers are toroid core transformers, the toroid core (140, 240, 340, 440) of each first transformer exhibiting a greater diameter than the toroid cores (40, 42) of the second transformers.

3. Device according to Claim 2, **characterized in that** the core (140, 240, 340, 440) of each first transformer is electrically linked to the secondary stage (128, 228, 328, 428) of the first transformer and the cores (40, 42) of the second transformers are electrically linked to the high-voltage circuit.

4. Device according to Claim 1, **characterized in that** it comprises a plurality of first toroid core transformers (118, 218, 318, 418) having their primary stages (122, 222, 322, 422) linked in series in the low-voltage circuit (16).

5. Device according to Claim 4, **characterized in that** the primary stages (122, 222, 322, 422) of the first transformers comprise a cable with high electrical insulation passing through the toroid cores of the first transformers.

6. Device according to Claim 4, **characterized in that** the low-voltage circuit (16) comprises a rigid metal rod (21) passing through the toroid cores of the first transformers (118, 218, 318, 418) and respectively forming their primary stage, the said rod being insulated from the cores by an insulating solid moulding (23).

7. Device according to Claim 1, **characterized in that** the secondary stage of each first transformer (118, 218, 318, 418) comprises a single winding (128, 228, 328, 428) linked to the first stages (130, 230) of a plurality of second transformers (120, 220) arranged in series.

8. Device according to Claim 7, **characterized in that** it comprises, for each plurality of second transformers (120, 220), an electrical link (511, 521) linking, at mid-voltage, a circuit (132, 232) comprising the primary stages (130, 230) of the plurality of second transformers, to a part of a branch (14) of the high-voltage circuit comprising the switches respectively linked to the said plurality of second transformers.

9. Device according to Claim 1, **characterized in that** the second transformers (120, 220) exhibit a secondary stage (34) with a single winding linked to a switch (10).

10. Device according to Claim 1, **characterized in that** the second transformers (120, 220) exhibit a plurality of windings (34, 34') linked respectively to a plurality of switches (10).

11. Device according to Claim 1, **characterized in that** the switches (10) comprise a control circuit (36) linked to the secondary stage (34, 34') respectively of the second transformers (120, 220) and comprising an insulated gate transistor (12) arranged in series in the high-voltage circuit.

12. Device according to Claim 11, **characterized in that** the transistor (12) is chosen from the group consisting of MOS, IGBT and MCT transistors.
